(19)

**Europäisches Patentamt**
**European Patent Office**
**Office européen des brevets**

(11) **EP 2 835 449 A1**

(12) **EUROPEAN PATENT APPLICATION**

(43) Date of publication:
**11.02.2015 Bulletin 2015/07**

(51) Int Cl.:
**C25B 15/00** *(2006.01)*   **C25B 15/08** *(2006.01)*
**C25B 1/00** *(2006.01)*   **C25B 1/04** *(2006.01)*
**C25B 9/00** *(2006.01)*   **C25B 9/04** *(2006.01)*
**H01L 31/048** *(2014.01)*

(21) Application number: **13425112.3**

(22) Date of filing: **05.08.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Badini, Angelo**
**00118 Roma (IT)**

(72) Inventor: **Badini, Angelo**
**00118 Roma (IT)**

(74) Representative: **Monelli, Alberto**
**Bugnion S.p.A.**
**Largo Michele Novaro 1/A**
**43121 Parma (IT)**

(54)   **Photovoltaic module for the production of hydrogen**

(57)   A photovoltaic module (1) for the production of hydrogen comprises a support and containment structure (2), at least a first photovoltaic group (3) housed in the support structure (2) and comprising a plurality of single photovoltaic cells (4), at least one electrolytic group (5) housed in the support and containment structure (2) and having an electrolytic chamber (6) for holding water containing electrolyte, electrodes (8) placed in the electrolytic chamber (6) and connected to the photovoltaic cells (4) of the first photovoltaic group (3), as well as an exit duct (9) for the hydrogen and oxygen gases produced by means of electrolysis.

FIG. 2

EP 2 835 449 A1

**Description**

The present invention relates to a photovoltaic module for the production of hydrogen gas.

As is known, photovoltaic modules, in particular in the form of photovoltaic panels, are used as current generators in photovoltaic plants and comprise a plurality of single photovoltaic cells.

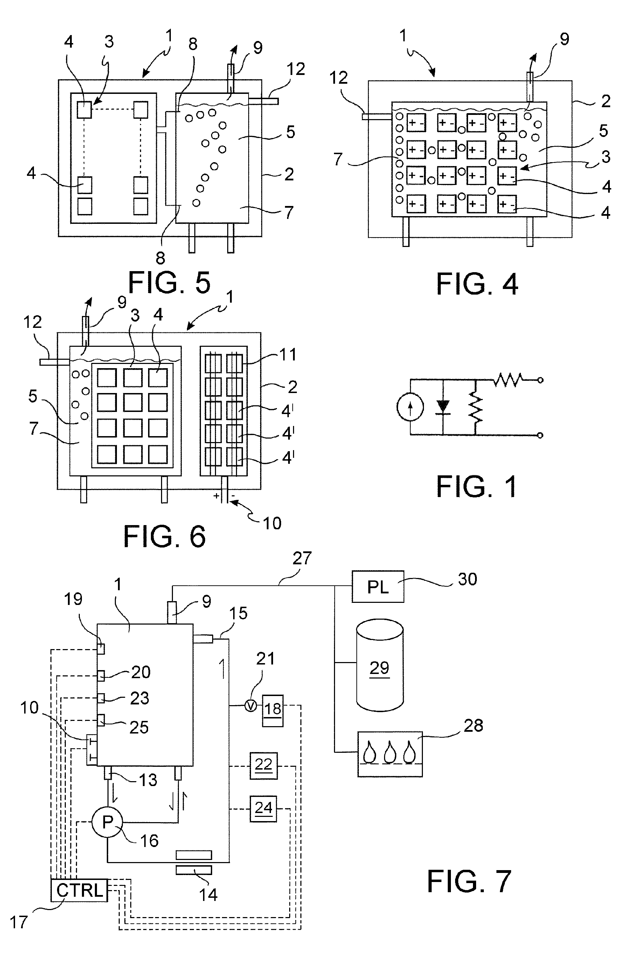

The single photovoltaic cell constitutes a basic element of a photovoltaic module. One type of photovoltaic cell which is very widespread is the photovoltaic cell in crystalline material, composed of a lamina of semiconductor material, in particular silicon, which transduces incident solar energy into electricity. One mathematical model often used to analyse the functioning of a photovoltaic cell is the Shockley ideal diode equation, according to which, starting from an equivalent circuit shown in Figure 1, the current on the load can be calculated using the formula:

$$I = I_s - I_0 \left( e^{\frac{qV_0}{\eta kT}} - 1 \right) - \frac{V_0}{R_p}$$

where "I" is the current intensity across the load, "V0" is the difference of potential between the two diode terminals, that is to say at no load ( with I equal to zero), "Is" is the current intensity produced by the generator which is proportional to the intensity of the incident radiation on the photovoltaic cell, "I0" is the saturation current intensity, a factor directly proportional to the surface of the p-n junction, "q" is the elementary load of the electron, "k" is the Boltzmann constant, "T" is the absolute temperature on the surface joining the p and n zones, "$\eta$" is the emission coefficient generally ranging from 1 to 2, "Rp" is the parallel resistance of the model.

In the known photovoltaic modules, for example in photovoltaic modules with photovoltaic cells in monocrystalline or polycrystalline silicone, each single photovoltaic cell is connected to the other photovoltaic cells by means of conductors (e.g. metal stripes), so as to form series and parallel circuits. The photovoltaic cells and metal conductors of the module are structurally combined in a structure (often multilayer) supported by a support panel and, often, by an outer frame in aluminium.

It is also known of to produce hydrogen gas by means of electrolysis and to use the hydrogen gas thus obtained as an immediately available utilisable fuel or fuel which can be stored without significant energy dissipation, for future use as fuel, for example, to produce electricity.

Electrolysis may take place in so-called electrolytic cells which comprise two electrodes of an inert metal (such as platinum) immersed in an electrolytic solution, in particular water, if necessary having electrolytic salts, and connected to a source of electric current. The electric current separates the water molecule into OH- and $H_3O+$ ions (and a very low percentage of free protons H+, which tend to react with the molecules of water to give $H_3O+$ ions). At the cathode the hydrogen ions ($H_3O+$) acquire electrons in a reduction reaction which leads to the formation of gaseous hydrogen $2H_2O + 2 e- \rightarrow H_2 + 2 OH-$. At the anode, the hydroxide ions (OH-) undergo oxidation, surrendering electrons $2H_2O \rightarrow O_2 + 4 H+ + 4 e-$. The following complete reaction $2H_2O \rightarrow 2 H_2 + O_2$ is obtained from the sum of the two previous half-reactions. As a result a volume of hydrogen almost double the volume of oxygen is formed (in that according to the ideal gas law the number of moles and volume are directly proportional), so that the oxygen having double the moles and molar volume of the hydrogen is $11.42 \times 10^{-3}$ $m^3$/mol, while for the oxygen it is $17.36 \times 10^{-3}$ $m^3$/mol, thus the hydrogen is almost double the volume of the oxygen.

The purpose of the present invention is to make available a photovoltaic module for the conversion of solar energy into electricity and for the production of hydrogen gas by means of electrolysis, wherein the photovoltaic module has structural and functional characteristics such as to perform the photovoltaic and hydrolysis function in an efficient manner with savings in terms of space, implementation and running costs and energy efficiency.

One particular purpose of the invention is to propose a photovoltaic module or system, in particular a photovoltaic panel, having characteristics such as to produce hydrogen gas and to:

**[0009]** - generate electric current for use other than electrolysis and /or

**[0010]** - to heat a fluid, such as water, in a heat exchange circuit.

At least some of such purposes are achieved by a photovoltaic module, in particular a photovoltaic panel, comprising:

**[0012]** - a support and containment structure,

**[0013]** - at least a first photovoltaic group housed in the support structure and comprising a plurality of single photovoltaic cells,

**[0014]** - at least one electrolytic group housed in the support and containment structure and having an electrolytic chamber for holding an electrolytic solution, in particular water, electrodes placed in the electrolytic chamber and connected to the photovoltaic cells of the first photovoltaic group, as well as an exit duct for the hydrogen and oxygen gases produced by means of electrolysis.

Thanks to the incorporation of the photovoltaic group and the electrolytic group in a single photovoltaic module, in particular in the same photovoltaic panel, the production of hydrogen occurs efficiently and with savings in terms of energy, space and running costs.

For a better understanding of the invention and its advantages, a description of some embodiments will be provided below by way of a non-limiting example, with reference to the appended drawings, wherein:

- figure 1 shows an equivalent circuit for a photovoltaic cell;
- figure 2 is an exploded perspective view of a photovoltaic panel according to one embodiment;
- figure 3 is an exploded perspective view of the photovoltaic panel in figure 1, in an assembled configuration;
- figure 4 is a schematised view of a photovoltaic module according to one embodiment;
- figure 5 is a schematised view of a photovoltaic module according to a further embodiment;
- figure 6 is a schematised view of a photovoltaic module according to a further embodiment;
- figure 7 is a schematised view of a system for producing hydrogen by means of the photovoltaic module according to one embodiment.

With reference to the figures, a photovoltaic module, in particular a photovoltaic panel is globally denoted by reference numeral 1. The photovoltaic module 1 comprises a support and containment structure 2, at least a first photovoltaic group 3 housed in the support structure 2 and comprising a plurality of single photovoltaic cells 4, as well as at least one electrolytic group 5 housed in the support and containment structure 2 and having an electrolytic chamber 6 for holding an electrolytic solution 7, in particular water, electrodes 8 placed in the electrolytic chamber 6 and connected to the photovoltaic cells 4 of the first photovoltaic group 3, as well as an exit duct 9 for the hydrogen and oxygen gases produced by means of electrolysis.

Thanks to the incorporation of the photovoltaic group 3 and the electrolytic group 5 in a single photovoltaic module 1, in particular in the same photovoltaic panel, the production of hydrogen occurs efficiently and with savings in terms of energy, space and running costs.

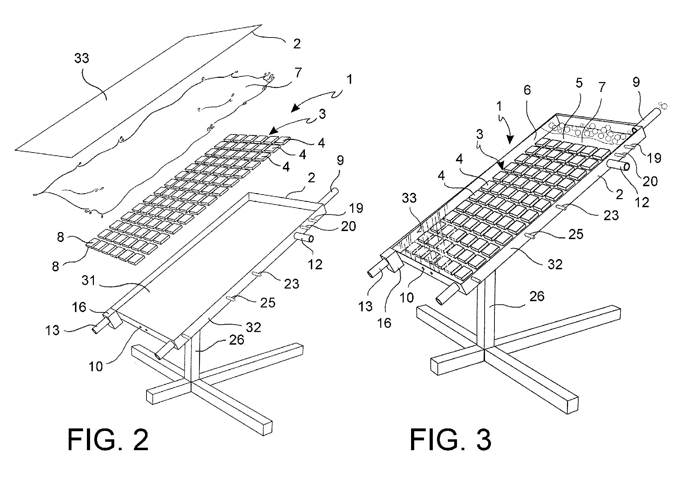

According to one embodiment, the first photovoltaic group 3, that is to say the single photovoltaic cells 4, may be placed directly inside the electrolytic chamber 6 so that the electrolytic solution, in particular water, is in direct contact with the single photovoltaic cells 4 which form a plurality of electrodes for electrolysis (Figures 2,3,4). To such purpose the single photovoltaic cells 4 are supported in the electrolytic chamber 6 distanced from each other , for example by means of a support framework in ceramic or plastic material or by means of gluing . The electrodes 8 may be made of an electrical conductor material highly resistant to electrochemical corrosion, such as steel, copper, silver, tin, platinum or gold.

According to an alternative embodiment (Figure 5), the electrolytic chamber 6 is separate and insulated from the first photovoltaic group 3, and the plurality of single photovoltaic cells 4 of the first photovoltaic group 3 are connected to each other by electric conductors in one or more circuits with respectively a pair of electric terminals forming the aforesaid electrodes 8 in the electrolytic chamber 6.

Moreover, at least some of the single photovoltaic cells 4 of the first photovoltaic group 3 may be connected to each other by electric conductors in a circuit with a pair of electric user terminals 10 for the supply of electric current.

According to a further embodiment (Figure 6), the photovoltaic module 1 may comprise at least a second photovoltaic group 11 (different from and in addition to the first photovoltaic group 3) housed in the support structure 2 and comprising a plurality of single photovoltaic cells 4' connected to each other by electric conductors in a circuit with a pair of electric user terminals 10 for the supply of electric current.

According to one embodiment, the photovoltaic module 1 comprises an entry duct 12 in communication with the electrolytic chamber 6, preferably opening into an upper region of the electrolytic chamber 6 in a position of use of the module 1, and suitable for connecting to a supply system of electrolytic fluid, in particular water. The photovoltaic module 1 may further comprises an exit duct 13 in communication with the electrolytic chamber 6, preferably opening into a lower region (or on the bottom) of the electrolytic chamber 6 in a position of use of the module 1, and suitable for connecting to a drainage system of the electrolytic fluid, in particular water.

According to one aspect of the invention the entry 12 and exit ducts 13 of one or more photovoltaic modules 1 may be connected in a filling and/or cooling circuit 15 to a water tank 18 or to the water supply for filling the electrolytic chamber with water 6 and/or with a heat exchanger 14 for the cooling of the photovoltaic module 1 and/or to exploit the thermal energy accumulated in the water during its transit through the electrolytic chamber 6 (Figure7). The filling and/or cooling circuit 15 comprises an electric pump 16 which may be electrically connected, possibly by means of the interposition of a control unit 17, to the electric user terminals of the at least one photovoltaic module 1.

This way, the filling and the recirculation of the water may take place automatically when the photovoltaic cells produce electricity and the electrolytic group produces hydrogen.

According to one embodiment, the electrolytic group 5 comprises one or more level sensors 19, 20 suitable for generating indicator signals of the level of water inside the electrolytic chamber 6. The level sensors may be connected to the control unit 17, which operates the pump 16 or a supply valve 21 depending on the level signals received from the level sensors 19, 20. In particular a maximum (upper) level sensor 19 and a minimum (lower) level sensor may be provided. When the level of water in the electrolytic chamber 6 falls below the minimum level, the control unit 17 operates the pump 17 or a supply valve 21 to fill the electrolytic chamber 6 and, when the level of water in the electrolytic chamber 6 exceeds the maximum level, the control unit 17 controls the pump 17 or the supply valve 21 to prevent further filling of the electrolytic chamber 6.

According to a further embodiment, an electric conductivity sensor 21 may be provided, placed in the electrolytic chamber 6 and suitable for generating an indicator signal of the electrolytic content of the water. The electric conductivity sensor 21 may also be connected to the control unit 17 which emits a corresponding visual or acoustic signal and/or operates an electrolyte supply device 22 connected to the water circuit 15, depending on the electric conductivity signals received from the electric conductivity sensor 21.

According to a further embodiment, a turbidity sensor 23 may be provided placed in the electrolytic chamber 6 and suitable for generating an indicator signal of the limpidity or turbidity of the water which are essential for the energy efficiency of the photovoltaic module 1. The turbidity sensor 23 may also be connected to the control unit 17, which emits a corresponding visual or acoustic signal and/or operates a detergent supply device 24 connected to the water circuit 15, depending on the turbidity signals received from the turbidity sensor 23.

Alternatively or in addition to the turbidity sensor 23 a power sensor 25 may be provided connected to one or more of the photovoltaic cells covered by water in the electrolytic chamber 6, wherein the power sensor 25 is suitable for generating an indicator signal of the limpidness or turbidity of the water. The power sensor 25 may also be connected to the control unit 17, which emits a corresponding visual or acoustic signal and/or operates the detergent supply device 24 connected to the water circuit 15, depending on the power signals received from the power sensor 25.

As already mentioned earlier, the photovoltaic module 1 is preferably incorporated in a single, structurally unitary and preferably self-supporting panel. The support and containment structure 2 may comprise a rear support wall (or layer) 31 and a side wall 32 which together form a flat box, closed (preferably hermetically) at the front by a transparent lid 33 or a front layer transparent to sunlight, so as to permit the solar radiation of the photovoltaic cells 4, 4'. By way of example, the electrolytic chamber 6 may have a thickness transversal to the plane of the photovoltaic panel 1 of approximately 1-3 cm, preferably approximately 2 cm.

The photovoltaic panel according to the present invention may be supported in the conventional manner on a stationary or adjustable support 26 and the gas exit duct 9 may be connected to a gas pipe 26 for connection to a utility such as a burner 28, a gas tank 29 or a gas pipeline 30.

Obviously, a person skilled in the art may make further modifications and variations to the photovoltaic module 1 and method according to the present invention so as to satisfy contingent and specific requirements, while remaining within the sphere of protection of the invention as defined by the following claims.


**Claims**

1. Photovoltaic module (1) for the production of hydrogen, comprising:

   - a support and containment structure (2),
   - at least a first photovoltaic group (3) housed in the support structure (2) and comprising a plurality of single photovoltaic cells (4),
   - at least one electrolytic group (5) housed in the support and containment structure (2) and having an electrolytic chamber (6) for holding water containing electrolyte, electrodes (8) placed in the electrolytic chamber (6) and connected to the photovoltaic cells (4) of the first photovoltaic group (3), as well as an exit duct (9) for the hydrogen and oxygen gases produced by means of electrolysis.

2. Photovoltaic module (1) according to claim 1, wherein the single photovoltaic cells (4) of the first photovoltaic group (3) are placed directly inside the electrolytic chamber (6) so that the water is in direct contact with the single photovoltaic cells (4) which form a plurality of electrodes for the electrolysis.

3. Photovoltaic module (1) according to claim 1, wherein the electrolytic chamber (6) is separate and insulated from the first photovoltaic group (3), and the single photovoltaic cells (4) of the first photovoltaic group (3) are connected to each other by electric conductors in one or more circuits with respectively a pair of electric terminals forming said electrodes (8) in the electrolytic chamber (6).

4. Photovoltaic module (1) according to claim 3, wherein at least some of the single photovoltaic cells (4) of the first photovoltaic group (3) are connected to each other by electric conductors in a circuit with a pair of electric user terminals (10) for the supply of electric current.

5. Photovoltaic module (1) according to one of the previous claims, comprising at least a second photovoltaic group (11) different from the first photovoltaic group (3), said second photovoltaic group (11) being housed in the support structure (2) and comprising a plurality of single photovoltaic cells (4') connected to each other by electric conductors in a circuit with a pair of electric user terminals (10) for the supply of electric current.

6. Photovoltaic module (1) according to any of the previous claims, configured as a structurally unitary and self-supporting panel.

7. Photovoltaic module (1) according to one of the previous claims, comprising:

   - an entry duct (12) in communication with the electrolytic chamber (6) and suitable for connecting to a water supply system,
   - an exit duct (13) in communication with the electrolytic chamber (6) and suitable for connecting to a water drainage system.

8. Photovoltaic system for the production of hydrogen, comprising one or more photovoltaic modules (1) according to claim 7, wherein the entry (12) and exit ducts (13) are connected in a filling circuit to a water tank (18) or to the water supply for filling the electrolytic chamber (6) with water, said filling circuit comprising an electric pump (16) electrically connected to the photovoltaic module (1.

9. Photovoltaic system according to claim 8, wherein the entry (12) and exit ducts (13) are connected in a cooling circuit (15) with a heat exchanger (14) for the cooling of the photovoltaic module (1) and to exploit the heat accumulated in the water in the electrolytic chamber, said filling circuit(15) comprising an electric pump (16) electrically connected to the photovoltaic module (1).

10. Photovoltaic system according to claim 8 or 9, wherein the electrolytic group (5) comprises one or more level sensors (19, 20) suitable for generating indicator signals of the level of water inside the electrolytic chamber (6), said level sensors (19, 20) being connected to a control unit (17) which operates the pump (16) or a supply valve (21) depending on the level signals received from the level sensors (19, 20).

11. Photovoltaic system according to one of the claims from 8 to 10, wherein the electrolytic group (5) comprises an electric conductivity sensor (21) placed in the electrolytic chamber (6) and suitable for generating an indicator signal of the electrolytic content of the water said electric conductivity sensor (21) being connected to a control unit (17) which operates an electrolyte supply device (22) connected to the filling circuit (15) depending on the signals received from the electric conductivity sensor (21).

12. Photovoltaic system according to one of the claims from 8 to 11, wherein the electrolytic group (5) comprises a turbidity sensor (23) placed in the electrolytic chamber (6) and suitable for generating an indicator signal of the turbidity of the water, said turbidity sensor (23) being connected to a control unit (17), which operates a detergent supply device (24) connected to the filling circuit (15) depending on the signals received from the turbidity sensor (23).

13. Photovoltaic system according to one of the claims from 8 to 12, wherein the first photovoltaic group (3) comprises a power sensor (25) connected to one or more of the photovoltaic cells (4) covered by the water in the electrolytic chamber (6), wherein the power sensor (25) is connected to the control unit (17), which operates a detergent supply device (24) connected to the filling circuit (15) depending on the signals received from the electric power sensor (25).

FIG. 5

FIG. 4

FIG. 6

FIG. 1

FIG. 7

FIG. 2

FIG. 3

**EP 2 835 449 A1**

Europäisches
Patentamt
European
Patent Office
Office européen
des brevets

**EUROPEAN SEARCH REPORT**

Application Number

EP 13 42 5112

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 736 912 A1 (NAKATA JOSUKE [JP]) 9 October 1996 (1996-10-09) * claims 1,9-12 * * example 4 * * column 3, line 55 - column 4, line 11 * * column 4, line 55 - column 5, line 8 * * column 5, lines 39-54 * * column 15, line 40 - column 16, line 3 * ----- | 1-13 | INV. C25B15/00 C25B15/08 C25B1/00 C25B1/04 C25B9/00 C25B9/04 H01L31/048 |
| X | US 2007/246370 A1 (DIMROTH FRANK [DE]) 25 October 2007 (2007-10-25) * claims 1,14,19-21,27-32 * * paragraphs [0011], [0019], [0020], [0022], [0023], [0032], [0038], [0048] * ----- | 1-13 | |
| X | WO 2008/144809 A1 (NEWSOUTH INNOVATIONS PTY LTD [AU]; ROSENGARTEN GARY [AU]; ZIMMERMAN RA) 4 December 2008 (2008-12-04) * claims 1,16,19,24,51 * * page 13, lines 16-32 * * page 24, lines 13-21 * ----- | 1-13 | TECHNICAL FIELDS SEARCHED (IPC) C25B H01L |
| X | US 2008/073205 A1 (ADIGA MAHABALA [US] ET AL) 27 March 2008 (2008-03-27) * claims 1-5,7,12-15 * * examples 1,3,5,6,12 * * paragraphs [0031] - [0038], [0045] - [0049], [0055], [0056] * ----- -/-- | 1-13 | |

The present search report has been drawn up for all claims

| Place of search | Date of completion of the search | Examiner |
|---|---|---|
| Munich | 30 January 2014 | Perednis, Dainius |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 13 42 5112

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2005/113859 A2 (HYDROGEN SOLAR LTD [GB]; KEABLE JULIAN MARTIN [GB]; AUTY DAVID HUGH [G)<br>1 December 2005 (2005-12-01)<br>* claims 1,4,12,13,16,23,24,29,31 *<br>* figures 3,4 *<br>* page 14, lines 5-8 *<br>* page 19, lines 12-23 *<br>* page 22, lines 8-14 *<br>* page 24, lines 14-16 *<br>----- | 1-13 | |

TECHNICAL FIELDS
SEARCHED (IPC)

The present search report has been drawn up for all claims

| Place of search | Date of completion of the search | Examiner |
|---|---|---|
| Munich | 30 January 2014 | Perednis, Dainius |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 13 42 5112

This annex lists the patent family members relating to the patent documents cited in the above-mentioned European search report.
The members are as contained in the European Patent Office EDP file on
The European Patent Office is in no way liable for these particulars which are merely given for the purpose of information.

30-01-2014

| Patent document cited in search report | | Publication date | Patent family member(s) | | Publication date |
|---|---|---|---|---|---|
| EP 0736912 | A1 | 09-10-1996 | AU | 2807895 A | 15-05-1996 |
| | | | CN | 1137840 A | 11-12-1996 |
| | | | EP | 0736912 A1 | 09-10-1996 |
| | | | JP | H08125210 A | 17-05-1996 |
| | | | US | 5785768 A | 28-07-1998 |
| | | | WO | 9613070 A1 | 02-05-1996 |
| US 2007246370 | A1 | 25-10-2007 | DE | 102004050638 B3 | 16-02-2006 |
| | | | EP | 1834012 A2 | 19-09-2007 |
| | | | US | 2007246370 A1 | 25-10-2007 |
| | | | WO | 2006042650 A2 | 27-04-2006 |
| WO 2008144809 | A1 | 04-12-2008 | NONE | | |
| US 2008073205 | A1 | 27-03-2008 | US | 2008073205 A1 | 27-03-2008 |
| | | | WO | 2006110613 A2 | 19-10-2006 |
| WO 2005113859 | A2 | 01-12-2005 | AU | 2005245663 A1 | 01-12-2005 |
| | | | EP | 1774060 A2 | 18-04-2007 |
| | | | JP | 2008507464 A | 13-03-2008 |
| | | | WO | 2005113859 A2 | 01-12-2005 |

EPO FORM P0459

For more details about this annex : see Official Journal of the European Patent Office, No. 12/82